# FASCICULE DE BREVET EUROPEEN

(11) **EP 3 840 558 B1**
(45) Date de publication et mention de la délivrance du brevet: **13.09.2023**
(21) Numéro de dépôt: 20214854.0
(22) Date de dépôt: 17.12.2020
(51) Int. Cl.: H05K 7/20

(54) **MODULE DE REFROIDISSEMENT POUR UNE ARMOIRE ÉLECTRIQUE**
KÜHLMODUL FÜR ELEKTRISCHEN SCHALTSCHRANK
COOLING MODULE FOR AN ELECTRICAL CABINET

(30) Priorité: 18.12.2019 FR 1914783
(43) Date de publication de la demande: 23.06.2021
(73) Titulaire: Schneider Electric Industries SAS, 92500 Rueil-Malmaison (FR)
(72) Inventeur: PERRIN, Alain, 38000 GRENOBLE (FR); LOPEZ, Josep, 38000 GRENOBLE (FR)
(74) Mandataire: Lavoix

(56) Documents cités:
- WO-A1-02/32202
- WO-A1-2010/009626
- US-A1- 2015 342 086

## Description

La présente invention concerne un module de refroidissement pour une armoire électrique, ainsi qu'une installation comprenant un tel module de refroidissement et une telle armoire électrique.

La présente invention se rapporte au domaine des dispositifs pour refroidir une armoire électrique par échange thermique air-air entre l'air extérieur et l'air contenu dans l'armoire, et/ou par ventilation, c'est-à-dire par renouvellement de l'air contenu dans l'armoire avec de l'air extérieur.

US 2015/342086 A1 décrit un dispositif de refroidissement monté sur la porte d'une armoire, qui comprend une chambre pour la circulation d'air extérieur et une chambre pour la circulation d'air intérieur, interposée entre l'armoire et la chambre pour la circulation d'air extérieur. Chaque chambre comprend une entrée d'air pourvue d'un ventilateur respectif pour faire circuler l'air en leur sein. La chambre pour la circulation d'air intérieur comprend un échangeur de chaleur, traversé par le flux d'air intérieur.

WO 02/32202 A1 concerne une armoire contenant un matériel électrique producteur de chaleur, pourvue d'un échangeur thermique à débit transversal air/air.

WO 2010/009626 A1 concerne un échangeur de chaleur, avec un conduit intérieur de circulation d'air et un conduit extérieur de circulation d'air à contre-courant, dont les entrées sont pourvues de ventilateurs.

Il est connu d'équiper une armoire électrique avec un dispositif échangeur air-air, qui est rapporté sur une paroi externe, par exemple une paroi latérale, appartenant à l'armoire. Le dispositif échangeur comprend une façade arrière, qui se trouve alors contre la paroi latérale de l'armoire, et une façade avant, tournée à l'opposé de la façade arrière. En son sein, le dispositif échangeur embarque un échangeur thermique, un ventilateur avant et un ventilateur arrière. La façade avant comprend une entrée avant basse et une sortie avant haute, alors que la façade arrière comprend une entrée arrière haute et une sortie arrière basse. Le ventilateur avant force une admission d'air extérieur par l'entrée avant basse, l'air extérieur étant refoulé par la sortie avant haute après avoir traversé l'échangeur. Le ventilateur arrière force une admission d'air provenant de l'armoire par l'entrée arrière haute, cet air étant refoulé vers l'armoire par la sortie arrière basse après avoir traversé l'échangeur. L'air extérieur et l'air de l'armoire électrique ne sont pas mis en contact, mais échangent seulement de la chaleur au travers de l'échangeur thermique. L'air extérieur étant plus froid que l'air de l'armoire électrique, l'air de l'armoire électrique est refroidi lorsqu'il traverse l'échangeur thermique. Grâce à ce dispositif, l'air de l'armoire est refroidi par l'air extérieur sans introduction d'air extérieur dans l'armoire. Ce mode de fonctionnement est particulièrement indiqué dans le cas où l'air extérieur est pollué et/ou chargé en particules, ce qui peut être le cas notamment dans une usine, puisqu'aucun air extérieur n'est admis dans l'armoire électrique.

Toutefois, à l'usage, il peut se produire un encrassement de l'échangeur thermique à cause de l'air extérieur. Du fait de cet encrassement, l'efficacité de l'échangeur thermique décroit avec le temps, de sorte que le dispositif d'échange thermique finit par ne plus assurer un refroidissement suffisant de l'armoire électrique. Le manque de refroidissement de l'armoire électrique constituant un risque critique pour l'intégrité de son contenu, il est alors nécessaire de mettre l'armoire électrique et le dispositif d'échange thermique à l'arrêt pour réaliser l'entretien de l'échangeur thermique.

L'invention propose notamment de porter remède à ces inconvénients en proposant un nouveau module de refroidissement qui, tout en étant particulièrement compact, évite une mise à l'arrêt de l'armoire électrique en cas de perte d'efficacité ou de dysfonctionnement de l'échangeur thermique air-air.

L'invention a pour objet un module de refroidissement, configuré pour être rapporté contre une façade extérieure d'une armoire électrique pour refroidir l'armoire électrique, le module de refroidissement comprenant : un échangeur thermique air-air ; une chambre primaire, délimitée par l'échangeur thermique et comprenant une ouverture primaire haute et une ouverture primaire basse, pour mettre en communication la chambre primaire avec l'extérieur ; des chambres secondaires, configurées pour être interposées entre la chambre primaire et l'armoire électrique lorsque le module de refroidissement est rapporté contre l'armoire électrique. Les chambres secondaires comprennent : une chambre secondaire haute, comprenant une ouverture secondaire haute, pour mettre en communication la chambre secondaire haute avec l'armoire électrique ; et une chambre secondaire basse, comprenant une ouverture secondaire basse, pour mettre en communication la chambre secondaire basse avec l'armoire électrique, la chambre secondaire haute communiquant avec la chambre secondaire basse par l'intermédiaire de l'échangeur thermique. Le module de refroidissement comprend des circulateurs d'air, qui, dans une configuration d'échange du module de refroidissement, mettent en circulation : un flux d'air primaire, successivement : via l'ouverture primaire basse, depuis l'extérieur jusque dans la chambre primaire ; au travers de l'échangeur thermique ; via l'ouverture primaire haute, depuis la chambre primaire jusqu'à l'extérieur, via l'ouverture primaire haute ; et un flux d'air secondaire, successivement : via l'ouverture secondaire haute, depuis l'armoire électrique jusque dans la chambre secondaire haute ; au travers de l'échangeur thermique ; via l'ouverture secondaire basse, depuis la chambre secondaire basse jusqu'à l'armoire électrique.

Selon l'invention, le module de refroidissement comprend une ouverture de ventilation haute, pour mettre en communication la chambre secondaire haute avec l'extérieur, et une ouverture de ventilation basse, pour mettre en communication le chambre secondaire basse avec la chambre primaire. Selon l'invention, le module de refroidissement est configuré pour être basculé entre la configuration d'échange, dans laquelle l'ouverture de ventilation haute et l'ouverture de ventilation basse sont fermées, et une configuration de ventilation, dans laquelle l'ouverture de ventilation haute et l'ouverture de ventilation basse sont ouvertes et dans laquelle les circulateurs d'air mettent en circulation : un flux d'air neuf, depuis l'extérieur jusque dans l'armoire électrique, successivement au travers de l'ouverture primaire basse, de l'ouverture de ventilation basse et de l'ouverture secondaire basse ; un flux d'air extrait, depuis l'armoire électrique jusqu'à l'extérieur, successivement au travers de l'ouverture secondaire haute et de l'ouverture de ventilation haute.

Grâce à l'invention, le module de refroidissement est hybride, et embarque à la fois une fonction d'échangeur air-air lorsqu'il est en configuration d'échange, et une fonction de refroidissement par renouvellement de l'air de l'armoire électrique lorsqu'il est en configuration de ventilation. Le module de refroidissement intégrant à la fois ces deux configurations de fonctionnement, dans une seule unité, il est particulièrement compact.

On prévoit avantageusement que le module de refroidissement fonctionne, à titre principal, en configuration d'échange. Dans ce mode de fonctionnement, on échange de la chaleur entre l'air intérieur de l'armoire, sous la forme du flux d'air secondaire, et l'air extérieur, sous la forme du flux d'air primaire, lorsque les flux d'air primaire et secondaire traversent l'échangeur. Pour que le module de refroidissement refroidisse l'intérieur de l'armoire, on prévoit que l'air extérieur est à une température inférieure à celle de l'air à l'intérieur de l'armoire, par exemple d'au moins 10°C (degrés Celsius). Cet échange de chaleur se fait sans mise en contact ni mélange du flux d'air primaire et du flux d'air secondaire. Ainsi, l'armoire électrique est refroidie sans introduction d'air neuf en son sein, provenant de l'extérieur, ce qui évite toute pollution de l'intérieur de l'armoire électrique par de l'air neuf. En cas de besoin, le module de refroidissement est apte à basculer en configuration de ventilation, qui est préférentiellement un mode de fonctionnement secondaire, un mode de fonctionnement de maintenance ou un mode de fonctionnement dégradé. En configuration de ventilation, l'air intérieur de l'armoire électrique est extrait de l'armoire électrique sous la forme du flux d'air extrait, et est remplacé par de l'air neuf, c'est-à-dire de l'air provenant de l'extérieur de l'armoire électrique et du module de refroidissement. En d'autres termes, le mode de ventilation vise à refroidir l'armoire électrique par renouvellement de l'air contenu dans l'armoire électrique par de l'air extérieur ou air neuf. Dans la configuration de ventilation, l'échangeur thermique n'est avantageusement pas utilisé pour refroidir l'armoire électrique. Par conséquent, la configuration de ventilation peut être mise en oeuvre dans certaines situations, par exemple lorsque l'échangeur thermique est encrassé ou dysfonctionnel, ou pour effectuer une opération de maintenance sur l'échangeur thermique, sans interrompre le fonctionnement de l'armoire électrique et du module de refroidissement.

D'autres caractéristiques optionnelles de l'invention sont définies comme suit.

De préférence, le module de refroidissement comprend : une façade primaire, qui délimite la chambre primaire, qui porte l'ouverture primaire haute et l'ouverture primaire basse ; et une façade secondaire, qui délimite la chambre secondaire haute et la chambre secondaire basse, qui porte l'ouverture secondaire basse et l'ouverture secondaire haute, qui est opposée et parallèle à la façade primaire, et qui est configurée pour être rapportée contre l'armoire électrique lorsque le module de refroidissement est rapporté contre l'armoire électrique.

De préférence, le module de refroidissement comprend : une ouverture d'extraction, ménagée au travers de la façade primaire ; et une chambre d'extraction, agencée au-dessus de la chambre primaire et mettant en communication l'ouverture de ventilation haute avec l'ouverture d'extraction, de sorte que, en configuration de ventilation, le flux d'air extrait est mis en circulation par les circulateurs d'air vers l'extérieur successivement au travers de la chambre d'extraction et de l'ouverture d'extraction, après que le flux d'air extrait ait traversé l'ouverture de ventilation haute.

De préférence, les circulateurs d'air comprennent : un circulateur primaire, qui est disposé à une ouverture d'entrée primaire de l'échangeur thermique, et qui, en configuration d'échange, force la circulation du flux d'air primaire, l'ouverture d'entrée primaire débouchant dans la chambre primaire ; un circulateur secondaire, qui est disposé à une ouverture d'entrée secondaire de l'échangeur thermique, et qui, en configuration d'échange, force la circulation du flux d'air secondaire, l'ouverture d'entrée secondaire débouchant dans la chambre secondaire haute ; et un circulateur de ventilation, qui est disposé à l'ouverture de ventilation basse ou à l'ouverture de ventilation haute et qui, en configuration de ventilation, force la circulation du flux d'air neuf et du flux d'air extrait.

De préférence, au moins une ouverture, parmi l'ouverture de ventilation basse et l'ouverture de ventilation haute, est configurée pour : être ouverte par l'action respectivement du flux d'air neuf et du flux d'air extrait ; et se refermer en l'absence du flux d'air neuf et du flux d'air extrait.

De préférence, le module de refroidissement comprend une cloison intermédiaire, qui sépare la chambre primaire vis-à-vis des chambres secondaires, les chambres secondaires communiquant avec l'échangeur thermique par l'intermédiaire de la cloison intermédiaire ; et l'échangeur thermique comprend un assemblage modulaire de plusieurs batteries d'échange thermique, l'assemblage modulaire étant monté sur la cloison intermédiaire, de façon que chaque batterie d'échange thermique soit accessible pour leur démontage depuis la chambre primaire, le nombre de batteries d'échange thermique montées sur la cloison intermédiaire déterminant la puissance spécifique de l'échangeur thermique.

De préférence, les batteries d'échange thermique sont agencées en colonne de sorte à être successivement traversées par le flux d'air secondaire, de la batterie d'échange thermique la plus haute jusqu'à la batterie d'échange thermique la plus basse.

De préférence, la cloison intermédiaire comprend des emplacements, chaque batterie d'échange thermique de l'assemblage modulaire pouvant être montée à l'un des emplacements, chaque emplacement comprenant une ouverture intermédiaire respective, débouchant sur la chambre secondaire basse, l'ouverture intermédiaire de chaque emplacement sur lequel une batterie d'échange thermique est montée étant recouverte par ladite batterie d'échange thermique, pour qu'une partie du flux d'air secondaire ayant traversé cette batterie d'échange thermique soit évacuée dans la chambre secondaire basse par l'intermédiaire de cette ouverture intermédiaire.

De préférence, le module de refroidissement comprend en outre un automate de commande et des capteurs de température, qui, en configuration d'échange, mesurent des températures du flux d'air primaire et/ou du flux d'air secondaire, l'automate de commande faisant automatiquement basculer le module de refroidissement de la configuration d'échange à la configuration de ventilation sur la base des températures mesurées par les capteurs de température.

L'invention a également pour objet une installation comprenant : le module de refroidissement qui précède ; et l'armoire électrique présentant la façade extérieure contre laquelle le module de refroidissement est rapporté, de sorte que : les chambres secondaires sont interposées entre l'armoire électrique et la chambre primaire ; et l'ouverture secondaire haute et l'ouverture secondaire basse débouchent à l'intérieur de l'armoire électrique.

Dans un mode de réalisation, on considère également une utilisation qui est faite de ce module de refroidissement, dans laquelle on fait basculer le module de refroidissement depuis la configuration d'échange vers la configuration de ventilation en fonction de températures des flux d'air circulant au sein du module de refroidissement.

L'invention sera mieux comprise à la lecture de la description qui suit, donnée uniquement à titre d'exemple non limitatif et faite en référence aux dessins annexés dans lesquels :
[Fig 1] La figure 1 est une vue en coupe schématique d'une installation comprenant un module de refroidissement conforme à l'invention.
[Fig 2] La figure 2 est un diagramme pour l'utilisation de l'installation de la figure 1.

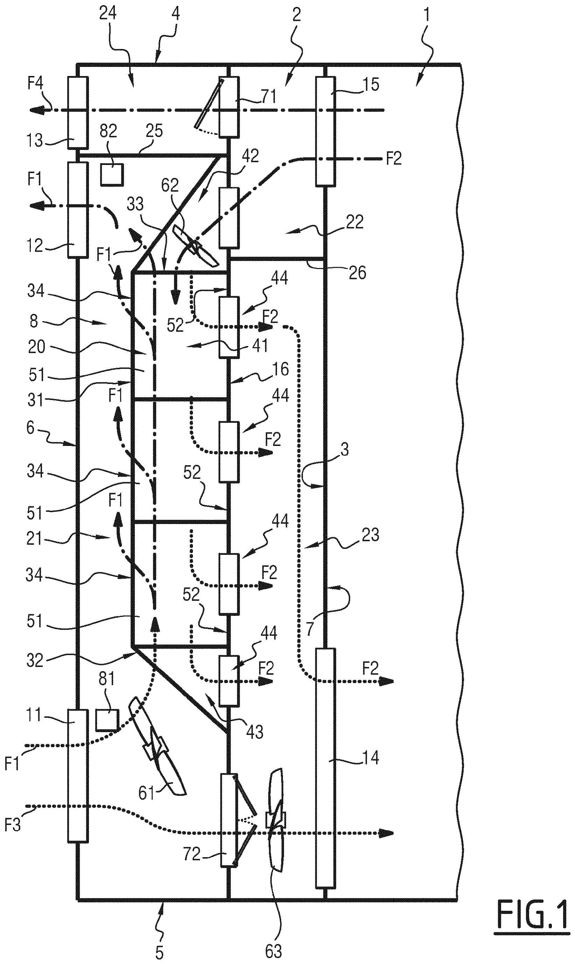

La figure 1 montre schématiquement une installation, incluant une armoire électrique 1 et un module de refroidissement 2, qui est rapporté contre une façade extérieure 3 de l'armoire électrique 1.

L'armoire électrique 1 est typiquement de forme parallélépipédique, et comprend un boîtier extérieur qui comprend la façade extérieure 3, qui est verticale, ainsi que trois autres façades extérieures verticales, un toit et un socle, formant une enceinte fermée. De préférence, l'une des façades extérieures de l'armoire 1 inclut, ou est formée par, une porte, pour accéder à l'intérieur de l'armoire électrique 1. De préférence, la façade 3 est une paroi latérale de l'armoire 1 dénuée de porte d'accès, de sorte que l'ouverture d'accès de l'armoire 1, formée sur une autre façade, est laissée libre par le module 2.

L'armoire électrique 1 renferme des composants électriques, électroniques ou informatiques, qui peuvent être de toute nature souhaitée, incluant par exemple des composants de conversion de puissance, un tableau électrique, un système informatique ou un serveur. Les composants de l'armoire 1 présentent la propriété d'émettre de la chaleur pendant leur fonctionnement. Il est donc nécessaire d'évacuer cette chaleur hors de l'armoire 1 pour assurer l'intégrité et le bon fonctionnement des composants.

Le module de refroidissement 2 est avantageusement disposé en applique sur l'armoire 1, c'est-à-dire que le module 2 est fixé à l'armoire 1 alors que l'armoire 1 est entièrement constituée. Le module 2 est donc fixé à l'extérieur de l'armoire 1. Ainsi rapporté sur l'armoire 1, le module 2 a pour fonction de refroidir l'intérieur de l'armoire 1, c'est-à-dire d'évacuer la chaleur émise par les composants hors de l'armoire 1.

Pour le refroidissement de l'armoire 1, le module 2 de refroidissement fonctionne selon deux configurations alternatives qui sont détaillées dans ce qui suit, à savoir une configuration d'échange où le module 2 met en oeuvre un flux d'air primaire F1 et un flux d'air secondaire F2, et une configuration de ventilation où le module met en oeuvre un flux d'air neuf F3 et un flux d'air extrait F4. Le module 2 est donc hybride, en présentant à la fois un fonctionnement dans lequel l'armoire 1 est refroidie par échange air-air sans introduction d'air neuf dans l'armoire 1, et un fonctionnement dans lequel, au contraire, l'armoire 1 est refroidie par apport d'air neuf.

Le module de refroidissement 2 comprend un unique boîtier, préférentiellement de forme parallélépipédique, qui constitue une enveloppe extérieure du module 2. Le module 2 est donc formé d'un seul tenant, et embarque toutes les fonctions dans un même boîtier. Le boîtier comprend avantageusement une paroi de toit 4 et une paroi de fond 5 opposées et horizontales. Le boîtier comprend avantageusement une façade primaire 6 et une façade secondaire 7 opposées, parallèles et verticales. Le boîtier comprend avantageusement deux façades latérales, dont une façade latérale 8 visible en arrière-plan sur la figure 1, les deux façades latérales étant opposées, parallèles et verticales. Chaque façade latérale est délimitée, à son périmètre, par la paroi de toit 4, la façade secondaire 7, la paroi de fond 5, et la façade primaire 6. Le boîtier définit donc avantageusement seulement six faces, formées par les parois 4 et 5 ainsi que par les façades primaire, secondaire et latérales.

Lorsque le module 2 est rapporté contre l'armoire 1, la façade secondaire 7 du module 2 est disposée contre la façade 3 de l'armoire 1. De préférence, le module 2 et/ou l'armoire comprend des moyens de fixation du module 2 sur l'armoire 1, par exemple un ensemble de vis ou de rivets implantés au travers des façades 3 et 7.

Le module de refroidissement 2 comprend une ouverture primaire basse 11, une ouverture primaire haute 12 et préférentiellement une ouverture d'extraction 13, qui sont toutes ménagées au travers de la façade primaire 6, pour mettre en communication l'intérieur du module 2 avec l'extérieur au travers de ces ouvertures 11, 12 et 13. De préférence, les ouvertures 11 et 12 sont réparties verticalement, l'ouverture primaire basse 11 étant située au-dessous de l'ouverture primaire haute 12. Si l'ouverture 13 est prévue, elle est disposée au-dessus de l'ouverture primaire haute 12.

Le module de refroidissement 2 comprend une ouverture secondaire basse 14 et une ouverture secondaire haute 15, qui sont toutes deux ménagées au travers de la façade secondaire 7, pour mettre en communication l'intérieur du module 2 avec l'intérieur de l'armoire 1. Pour cela, la façade 3 de l'armoire 1 comprend avantageusement des ouvertures correspondant aux ouvertures 14 et 15 du module 2. De préférence, les ouvertures 14 et 15 sont réparties verticalement, l'ouverture secondaire basse 14 étant située au-dessous de l'ouverture secondaire haute 15. De préférence, l'ouverture secondaire basse 14 est située à hauteur de l'ouverture primaire basse 11. De préférence, l'ouverture secondaire haute 15 est située à hauteur de l'ouverture primaire haute 12 et/ou de l'ouverture d'extraction 13.

Par « l'extérieur », on entend l'extérieur du module 2 et de l'armoire 1. Par « mettre en communication », on entend autoriser le passage d'un flux d'air. De préférence, chaque ouverture se présente sous la forme d'une grille ou de persiennes pour permettre le passage de l'air tout en empêchant l'introduction de corps étrangers dans le module 2. Une ouverture peut être constituée d'une pluralité d'ouvertures élémentaires, disposées dans une même zone.

De préférence, le boîtier du module de refroidissement 2 ne comprend pas d'autre ouverture que les ouvertures 11, 12, 13, 14 et 15, pour mettre en communication l'intérieur du module 2 soit avec l'intérieur de l'armoire 1, soit avec l'extérieur.

Le module 2 comprend une cloison intermédiaire 16, qui s'étend à l'intérieur du boîtier. La cloison 16 est préférentiellement plane et parallèle aux façades 6 et 7, elles-mêmes planes. La cloison 16 est disposée entre les façades 6 et 7. La cloison 16 est préférentiellement délimitée, à son périmètre, par les parois 4 et 5 ainsi que par les deux façades latérales du module 2, dont la façade latérale 8. La cloison 16 sépare donc le module 2 en deux parties, l'une en direction de la façade primaire 6 et l'autre en direction de la façade secondaire 7.

Le module 2 comprend un échangeur thermique air-air 20, une chambre primaire 21, une chambre secondaire haute 22, une chambre secondaire basse 23 et optionnellement une chambre d'extraction 24. La chambre primaire 21, et la chambre d'extraction 24, si elle est prévue, sont délimitées entre la façade primaire 6 et la cloison 16. De préférence, l'échangeur thermique est disposé entre la façade primaire 6 et la cloison 16. Les chambres secondaires 22 et 23 sont délimitées entre la cloison 16 et la façade secondaire 7. Ainsi, la cloison intermédiaire 16 sépare la chambre primaire 21 et la chambre d'extraction 24 optionnelle vis-à-vis des chambres secondaires 22 et 23. Lorsque le module 2 est installé sur l'armoire 1, les chambres secondaires 22 et 23 se trouvent horizontalement interposées entre d'une part l'armoire 1 et d'autre part les chambres 21 et 24.

La chambre primaire 21 est délimitée, dans le sens horizontal, par la façade primaire 6 dans une direction opposée à l'armoire 1, et par la cloison 16 et l'échangeur thermique 20 en direction de l'armoire 1. Dans le sens vertical, la chambre primaire 21 est délimitée par la paroi 5, vers le bas, et par la chambre d'extraction 24 vers le haut. La chambre primaire 21 comprend l'ouverture primaire basse 11 et l'ouverture primaire haute 12, lesquelles mettent en communication la chambre primaire 21 avec l'extérieur, directement au travers de la façade 6. L'ouverture primaire haute 12 est agencée à une extrémité haute de la chambre 21, alors que l'ouverture primaire basse 11 est agencée à une extrémité basse de la chambre 21.

De préférence, la façade primaire 6 est amovible, ou comprend une porte d'accès qui est normalement fermée pendant le fonctionnement du module 2 et qui peut être ouverte, pour qu'un opérateur puisse accéder à l'intérieur de la chambre primaire 21 depuis l'extérieur au travers de la façade 6, pour effectuer des opérations de maintenance, notamment concernant l'échangeur 20.

Dans le cas illustré, l'échangeur thermique 20 s'étend entièrement entre la cloison 16 et la façade 6, en étant contre la cloison 16 mais pourrait être reçu dans la chambre primaire 21 en étant distant de la cloison 16, ou être positionné à cheval sur la cloison 16, tant qu'au moins une partie de l'échangeur 20 est accessible depuis la chambre primaire 21, notamment pour faciliter la maintenance de l'échangeur 20.

La chambre d'extraction 24, si elle est prévue, est délimitée, dans le sens horizontal, par la façade primaire 6 dans une direction opposée à l'armoire 1, et par la cloison 16 en direction de l'armoire 1. Dans le sens vertical, la chambre d'extraction 24 est délimitée par la chambre 21, vers le bas, et par la paroi 5 vers le haut. Les chambres 21 et 24 sont donc agencées verticalement, la chambre 24 étant au-dessus de la chambre 21, en étant adjacentes. La chambre d'extraction 24 comprend l'ouverture d'extraction 13, qui met en communication la chambre d'extraction 24 avec l'extérieur, directement au travers de la façade 6.

On prévoit avantageusement que les chambres 21 et 24 sont séparées par une cloison 25, par exemple horizontale, de façon que de l'air présent dans l'une des deux chambres 21 et 24 ne puisse pas être directement admis dans l'autre des deux chambres 21 et 24.

La chambre secondaire basse 23 est délimitée, dans le sens horizontal, par la cloison 16, c'est-à-dire par la chambre 21 et par l'échangeur 20 dans une direction opposée à l'armoire 1, et par la façade secondaire 7 en direction de l'armoire 1. La chambre secondaire basse 23 est donc adjacente à la chambre primaire 21. Dans le sens vertical, la chambre secondaire basse 23 est délimitée par la paroi 5 vers le bas, et par la chambre secondaire haute 22 vers le haut. La chambre secondaire basse 23 comprend l'ouverture secondaire basse 14, laquelle met en communication la chambre secondaire basse 23 avec l'armoire, directement au travers de la façade 7 et de la façade 3. L'ouverture secondaire basse 14 est agencée à une extrémité basse de la chambre 23. De préférence, une extrémité haute de la chambre secondaire basse 23 s'étend au-dessous de l'extrémité haute de la chambre primaire 21, en particulier au-dessous de l'ouverture primaire haute 12.

La chambre secondaire haute 22 est délimitée, dans le sens horizontal, par la cloison 16, c'est-à-dire au moins en partie par la chambre 21, et de préférence, par la chambre d'extraction 24 dans une direction opposée à l'armoire 1. La chambre secondaire haute 22 est délimitée par la façade secondaire 7 en direction de l'armoire 1. La chambre secondaire haute 22 est donc adjacente à la chambre primaire 21 et, de préférence, à la chambre d'extraction 24. Dans le sens vertical, la chambre secondaire haute 22 est délimitée par la chambre 23 vers le bas, et par la paroi 4 vers le haut. Les chambres 22 et 23 sont donc agencées verticalement, la chambre 22 étant au-dessus de la chambre 23, les chambres 22 et 23 étant verticalement adjacentes. La chambre secondaire haute 22 comprend l'ouverture secondaire haute 15, laquelle met en communication la chambre secondaire haute 22 avec l'armoire, directement au travers de la façade 7 et de la façade 3. De préférence, une extrémité basse de la chambre secondaire haute 22 s'étend au-dessous de l'extrémité haute de la chambre primaire 21, en particulier au-dessous de l'ouverture primaire haute 12.

On prévoit avantageusement que les chambres 22 et 23 sont séparées par une cloison 26, par exemple horizontale, de façon que de l'air présent dans l'une des deux chambres 22 et 23 ne puisse pas être directement admis dans l'autre des deux chambres 22 et 23.

En configuration d'échange, l'ouverture 11 est traversée par le flux d'air primaire F1, qui circule depuis l'extérieur jusqu'à l'intérieur de la chambre 21. A cet endroit, le flux d'air primaire F1 est au plus froid, à une température T1 qui correspond approximativement à la température ambiante extérieure. En configuration d'échange, l'ouverture 12 est traversée par le flux d'air primaire F1, qui circule depuis l'intérieur de la chambre 21 jusqu'à l'extérieur. A cet endroit, le flux d'air primaire F1 est au plus chaud, à une température T2, car il a transmis ses frigories à l'intérieur du module 2. En configuration d'échange, l'ouverture 15 est traversée par le flux d'air secondaire F2, qui va de l'intérieur de l'armoire 1 jusqu'à l'intérieur de la chambre 22. A cet endroit, le flux d'air F2 est le plus chaud pour le flux F2, à une température T3, car le flux F2 émane de l'armoire 1 sans encore avoir été refroidi par le module 2. En configuration d'échange, l'ouverture 14 est traversée par le flux d'air secondaire F2, qui va de l'intérieur de la chambre 23 jusqu'à l'intérieur de l'armoire 1. A cet endroit, le flux d'air secondaire F2, est à une température T4, au plus froid pour le flux F2, car le flux F2 a été refroidi au sein du module 2. Néanmoins la température T4 du flux d'air F2 traversant l'ouverture 14 est nécessairement plus élevée que la température T1 du flux d'air F1 traversant l'ouverture 11. Sur la figure 1, on a représenté les flux d'air F1, F2, F3 et F4 avec un trait mixte, lorsque l'air est chaud, et avec un trait discontinu, lorsque l'air est froid.

L'échangeur thermique 20 est avantageusement disposé selon un agencement vertical le long de la cloison 16.

L'échangeur thermique 20 comprend un circuit primaire 31, qui peut se présenter sous la forme d'un réseau de conduits, de plaques, ou d'une face pourvue de reliefs tels que des ailettes. En configuration d'échange, le circuit primaire 31 est propre à être traversé par le flux d'air primaire F1 circulant dans la chambre 21, de bas en haut. Pour cela, le circuit primaire 31 comprend une ouverture d'entrée primaire 32, débouchant à l'intérieur de la chambre 21, par exemple à proximité de l'ouverture 11, et une ouverture de sortie primaire 33, débouchant à l'intérieur de la chambre 21, par exemple à proximité de l'ouverture 12, le flux F1 traversant l'échangeur 20 en traversant successivement l'ouverture d'entrée 32, le circuit 31 et l'ouverture de sortie 33. De préférence, l'ouverture d'entrée 32 est disposée en bas du circuit 31 et l'ouverture de sortie 33 en haut du circuit 31, par exemple à la verticale de l'ouverture d'entrée 32. Comme montré sur la figure 1, le circuit 31 comprend optionnellement des ouvertures auxiliaires 34, ici au nombre de trois, réparties sur la hauteur de l'échangeur 20, entre l'ouverture 32 et l'ouverture 33, pour qu'une partie du flux F1 soit évacuée hors de l'échangeur 20 jusque dans la chambre 21 de façon répartie sur la hauteur de l'échangeur 20. Lors de sa circulation dans le circuit 31, le flux F1 se charge avec de la chaleur du flux F2, et est donc réchauffé.

L'échangeur thermique 20 comprend un circuit secondaire 41, qui peut se présenter sous la forme d'un réseau de conduits, de plaques, ou d'une face pourvue de reliefs tels que des ailettes. En configuration d'échange, le circuit secondaire 41 est propre à être traversé par le flux d'air secondaire F2 circulant dans les chambres 22 et 23, de haut en bas. Pour cela, le circuit secondaire 41 comprend une ouverture d'entrée secondaire 42, débouchant à l'intérieur de la chambre 22 en traversant la cloison 16, par exemple à hauteur de l'ouverture 15, et une ouverture de sortie secondaire 43, débouchant à l'intérieur de la chambre 23 en traversant la cloison 16, par exemple à hauteur de l'ouverture 14, le flux F2 traversant l'échangeur 20 en traversant successivement l'ouverture 42, le circuit 41 et l'ouverture 43. De préférence, l'ouverture d'entrée 42 est disposée en haut du circuit 41 et l'ouverture de sortie 43 en bas du circuit 41, par exemple à la verticale de l'ouverture d'entrée 42. Comme montré sur la figure 1, le circuit 41 peut comprendre des ouvertures intermédiaire 44 réparties sur la hauteur de l'échangeur 20, entre l'ouverture 42 et l'ouverture 43, pour qu'une partie du flux F2 soit évacuée hors de l'échangeur 20 jusque dans la chambre 23 de façon répartie sur la hauteur de l'échangeur 20. Lors de sa circulation dans le circuit 41, le flux F2 transmet de la chaleur au flux F2 et est donc refroidit. Grâce aux ouvertures 44, l'émission du flux F2 hors de l'échangeur 20 est réparti dans la chambre 23.

Du fait de cette configuration pour la circulation des flux d'air F1 et F2, on utilise l'échangeur thermique 20 pour un échange à contre-courant. L'échangeur 20 est configuré pour que, lors du passage des flux d'air F1 et F2 en son sein, les flux d'air F1 et F2 ne sont pas mélangés ou mis en contact, mais sont au contraire maintenus séparés. En particulier, les circuits 31 et 41 sont non communicants. Plus généralement, le module 2 est entièrement conçu pour que les flux d'air F1 et F2 n'entrent pas en contact.

Les chambres 22 et 23 sont mises en communication par l'intermédiaire de l'échangeur thermique 20, en particulier, par l'intermédiaire du circuit secondaire 41. Dans le présent exemple, cette mise en communication est effectuée par l'intermédiaire de la cloison intermédiaire 16, puisque l'échangeur 20 est situé de l'autre côté de la cloison intermédiaire 16 par rapport aux chambres 22 et 23. Par exemple, les ouvertures 42 et 43 se présentent sous la forme de conduits reliant l'échangeur 20 à la cloison 16 et s'ouvrant respectivement sur les chambres 22 et 23.

En variante, le circuit primaire 31 de l'échangeur 20 peut être partiellement ou entièrement ouvert sur la chambre 21, en étant formé seulement par un réseau de gorges débouchant sur la chambre 21. De façon additionnelle ou alternative, le circuit secondaire 41 de l'échangeur 20 peut être partiellement ou entièrement ouvert sur les chambres 22 et 23, en étant formé seulement par un réseau de gorges débouchant sur les chambres 22 et 23. Dans ce cas, la cloison 16 est absente ou, pour le moins, est largement ouverte pour que l'échangeur soit ouvert sur les chambres 22 et 23. Dans cette variante, l'échangeur sépare les chambres secondaires 22 et 23 vis-à-vis de la chambre primaire 21.

De façon préférentielle, l'échangeur thermique 20 comprend un assemblage modulaire de plusieurs batteries 51 d'échange thermique individuelles, identiques, ou pour le moins interchangeables. Chaque batterie 51 est un échangeur thermique air-air élémentaire, par exemple un radiateur métallique à plaques, à tubes ou à ailettes.

L'assemblage modulaire est monté sur la cloison intermédiaire 16, de façon que chaque batterie d'échange thermique 51 soit accessible pour le montage et le démontage depuis la chambre primaire 21, en particulier depuis la façade primaire 6. En d'autres termes, chaque batterie 51 montée est accessible depuis la chambre 21. En pratique, les batteries 51 montées sur la cloison 16 délimitent ou bordent la chambre 21. Les batteries 51 montées sont avantageusement disposées dans un même plan, qui est par exemple parallèle à la cloison 16, entre la cloison 16 et la façade 6. Sur la figure 1, trois batteries 51 sont représentées montées.

Les batteries 51 montées constituent ensemble le circuit primaire 31 et le circuit secondaire 41. Toutes les batteries 51 de l'assemblage modulaire qui sont montées sur la cloison 16 sont avantageusement agencées en série, de sorte à être successivement traversées d'une part par le flux d'air primaire F1, et d'autre part par le flux d'air secondaire F2. Chaque batterie 51 montée reçoit au moins une partie du flux d'air secondaire F2 d'une autre batterie 51 montée, ou de l'ouverture 42. Chaque batterie montée 51 est traversée par ladite au moins une partie du flux d'air secondaire F2 et transmet une partie de cet air à la batterie 51 montée subséquente, ou à l'ouverture 43. Chaque batterie 51 montée reçoit au moins une partie du flux d'air primaire F1 d'une autre batterie 51 montée, ou de l'ouverture 32. Le circuit primaire 31 traverse successivement, de bas en haut, toutes les batteries 51 montées. Le circuit secondaire 41 traverse successivement, de haut en bas, toutes les batteries 51 montées. Chaque batterie montée 51 est traversée par ladite au moins une partie du flux d'air primaire F1 et transmet une partie de cet air à la batterie 51 montée subséquente, ou à l'ouverture 33. De préférence les batteries 51 montées sont agencées selon un unique colonne, c'est-à-dire verticalement, de sorte que le flux F1 traverse successivement les batteries 51 montées en partant de la batterie le plus bas jusqu'à la batterie le plus haut, et de sorte que le flux F2 traverse successivement les batteries 51 montées en partant de la batterie 51 le plus haut jusqu'à la batterie 51 le plus bas. En variante, on prévoit que les batteries 51 montées sont agencées selon plusieurs colonnes parallèles réparties dans un plan parallèle à la cloison 16. Dès lors, les circuits 31 et 41 comprennent plusieurs branches parallèles pour diviser la circulation des flux F1 et F2. Chaque batterie 51 forme avantageusement l'une des ouvertures 34.

Quel que soit la disposition et la répartition des batteries montées 51, le nombre de batteries 51 montées sur la cloison intermédiaire 16 détermine la puissance spécifique de l'échangeur thermique 20, puisque le nombre de batterie 51 montées détermine les dimensions et la structure des circuits 31 et 41, et donc la surface d'échange de chaleur de l'échangeur 20. La puissance spécifique de l'échangeur 20 augmente avec le nombre de batteries 51 montées sur la cloison 16. La puissance spécifique est parfois appelée conductance thermique et s'exprime en W/K (Watt par Kelvin). Un même module 2 peut donc facilement être adapté à l'armoire 1 sur lequel ce module 2 est monté, surtout dans la mesure où les armoires 1 sont généralement elles-mêmes évolutives. Pour augmenter la puissance spécifique installée sur l'armoire 1, il n'est donc pas nécessaire de prévoir plusieurs modules de refroidissement, puisque la modularité de la puissance spécifique est intégrée dans un seul module 2. Il en résulte une compacité de l'ensemble et une facilité d'installation et de modification de la puissance spécifique d'échange thermique. En outre, la puisse spécifique étant déterminée au sein d'un même module de refroidissement, la responsabilité de la puissance spécifique effective pèse sur le constructeur du module plutôt que sur l'installateur du module.

Pour le montage des batteries 51, la cloison 16 comprend des emplacements 52 correspondants, ici au nombre de trois, qui sont répartis sur sa surface tournée vers la chambre 21, chaque emplacement 52 étant susceptible d'accueillir l'une des batteries 51. Dans le cas où l'on prévoit d'agencer les batteries 51 selon une colonne, les emplacements 52 sont également agencés en colonne sur la cloison 16. Plus généralement, l'agencement des emplacements 52 détermine l'agencement des batteries 51 montées. Sur la figure 1, chaque emplacement est occupé par l'une des batteries 51, et aucun n'est laissé libre. Chaque emplacement 52 comprend avantageusement des moyens de fixation amovible de l'une des batteries 51 sur cet emplacement 52, tels que des crochets ou des orifices de vissage. De préférence, chaque batterie 51 peut être indifféremment montée, de façon amovible, sur n'importe lequel des emplacements 52. Chaque emplacement 52 est préférentiellement superposé sur l'une des ouvertures intermédiaire 44, de sorte que si une batterie 51 est montée sur cet emplacement, cette batterie 51 recouvre l'ouverture 44, pour qu'une partie du flux d'air secondaire F2 qui traverse cette batterie 51 soit évacuée dans la chambre secondaire basse 23, alors qu'une autre partie du flux d'air secondaire F2 est admise dans la batterie 51 suivante, ou dans l'ouverture de sortie 43. En pratique, un emplacement 52 dénué de batterie 51 est préférentiellement occupé par une pièce de bipasse, qui peut par exemple se présenter sous la forme d'un simple conduit, reliant la batterie 51 de l'emplacement 52 précédent, ou l'ouverture 42, à la batterie 51 de l'emplacement 52 suivant, ou à l'ouverture 43. Lorsqu'un emplacement 52 est laissé libre, on peut choisir d'obturer ou, au contraire, de laisser libre l'ouverture 44 correspondant.

Le module 2 comprend des circulateurs d'air, dont un circulateur primaire 61, qui se présente par exemple sous la forme d'un impulseur ou ventilateur, pour forcer la circulation du flux d'air F1 en configuration d'échange. Avantageusement, ce circulateur 61 est prévu à l'ouverture d'entrée primaire 32 de l'échangeur 20. En particulier, ce circulateur 61 est prévu dans la chambre 21 entre l'ouverture 11 et l'ouverture 32. On pourrait prévoir en outre ou alternativement un circulateur primaire à l'ouverture de sortie primaire 33, pour forcer la circulation du flux F1 en configuration d'échange. Pour résumer, en configuration d'échange, le ou les circulateurs primaires 61 mettent en circulation le flux d'air F1 successivement, en premier lieu, via l'ouverture 11, depuis l'extérieur jusque dans la chambre 21, en second lieu au travers du circuit primaire 31 de l'échangeur 20, et en troisième lieu via l'ouverture 12, depuis la chambre 21 vers l'extérieur.

Parmi les circulateurs d'air, le module 2 comprend un circulateur secondaire 62, qui se présente par exemple sous la forme d'un impulseur ou ventilateur, pour forcer la circulation du flux d'air F2 en configuration d'échange. Avantageusement, ce circulateur 62 est prévu à l'ouverture d'entrée secondaire 42 de l'échangeur 20. En particulier, ce circulateur 62 est prévu dans le conduit constituant l'ouverture 32, entre la cloison 16 et la façade 6. Ce circulateur 62 aurait pu être prévu dans la chambre 22. On pourrait prévoir en outre ou alternativement un circulateur secondaire à l'ouverture de sortie secondaire 43, pour forcer la circulation du flux F2 en configuration d'échange. Pour résumer, en configuration d'échange, le ou les circulateurs secondaires 62 mettent en circulation le flux d'air F2 successivement, en premier lieu, via l'ouverture 15, depuis l'armoire 1 jusque dans la chambre 22, en second lieu au travers du circuit secondaire 41 de l'échangeur 20, et en troisième lieu via l'ouverture 14, depuis la chambre 23 vers l'armoire 1.

En configuration de ventilation, les circulateurs 61 et 62 sont avantageusement arrêtés, de sorte que les flux F1 et F2 ne sont plus mis en circulation. En configuration de ventilation, l'ouverture 11 est traversée par le flux d'air neuf F3, qui circule depuis l'extérieur jusqu'à l'intérieur de la chambre 21. Par « air neuf », on entend seulement qu'il s'agit d'air provenant de l'extérieur du module 2 et de l'armoire 1, sans préjuger de son éventuelle pollution. En particulier, l'air neuf est susceptible d'être pollué par des poussières flottant dans l'environnement extérieur immédiat du module. En configuration de ventilation, l'ouverture 14 est traversée par le flux d'air neuf F3, qui circule depuis la chambre 23 jusqu'à l'intérieur de l'armoire 1 pour refroidir l'armoire 1 par apport d'air neuf. En configuration de ventilation, l'ouverture 15 est traversée par le flux d'air extrait F4, qui circule depuis l'intérieur de l'armoire 1 jusqu'à la chambre 22, pour laisser la place à l'air neuf du flux F3 à l'intérieur de l'armoire 1. En configuration de ventilation, l'ouverture 13, si elle est prévue, est traversée par le flux d'air extrait F4, qui circule depuis la chambre d'extraction 24 jusqu'à l'extérieur.

Pour son fonctionnement en configuration de ventilation, le module 2 comprend une ouverture de ventilation haute 71, une ouverture de ventilation basse 72 et avantageusement, parmi les circulateurs d'air, un circulateur de ventilation 63.

De préférence, les ouvertures 71 et 72 sont ménagées au travers de la cloison 16. L'ouverture 71 est au-dessus de l'ouverture 72. Les ouvertures 71 et 72 sont par exemple réparties verticalement. L'ouverture 71 est par exemple à la même hauteur que l'ouverture 13 et/ou l'ouverture 15. L'ouverture 72 est par exemple à la même hauteur que l'ouverture 11 et/ou l'ouverture 14.

L'ouverture de ventilation haute 71 adopte une position ouverte dans laquelle elle met en communication la chambre secondaire haute 22 avec la chambre d'extraction 24, et une position fermée dans laquelle l'ouverture 71 est obturée, par exemple par un clapet, préférentiellement un clapet anti-retour, pour s'opposer au passage d'air au travers de l'ouverture 71. En configuration d'échange, l'ouverture 71 est fermée alors que, en configuration de ventilation, l'ouverture 71 est ouverte pour être traversée par le flux d'air extrait F4, depuis la chambre 22 vers la chambre 24, c'est-à-dire vers l'extérieur par l'intermédiaire de l'ouverture 13. En d'autres termes, dans le mode de réalisation illustré, en configuration de ventilation, le flux d'air extrait F4 est mise en circulation vers l'extérieur successivement au travers de la chambre d'extraction 24 et de l'ouverture d'extraction 13, après que le flux d'air extrait F4 ait traversé l'ouverture de ventilation haute 71 et la chambre 22. Cela permet notamment de prévoir toutes les ouvertures donnant sur l'extérieur sur une même façade, ici la façade primaire 6, afin que de pouvoir utiliser un boîtier de forme parallélépipédique polyvalent, facile à concevoir, à fabriquer et à transporter.

En variante, dans le cas où la chambre d'extraction 24 n'est pas prévue, l'ouverture 71 met en communication la chambre 22 directement avec l'extérieur lorsque l'ouverture 71 est ouverte. Dès lors, en configuration de ventilation, l'ouverture 71 est traversée par le flux d'air extrait F4, depuis la chambre 22 directement vers l'extérieur. Dans cette variante, l'ouverture 71 peut être formée dans la façade 6, la chambre 22 s'étendant avantageusement de façon non cloisonnée à l'emplacement des chambres 22 et 24 illustrées.

L'ouverture de ventilation basse 72 adopte une position ouverte dans laquelle elle met en communication la chambre primaire 21 avec la chambre secondaire basse 23, et une position fermée dans laquelle l'ouverture 72 est obturée, par exemple par un clapet, préférentiellement un clapet anti-retour, pour s'opposer au passage d'air au travers de l'ouverture 72. En configuration d'échange, l'ouverture 72 est fermée alors que, en configuration de ventilation, l'ouverture 72 est ouverte pour être traversée par le flux d'air neuf F3, depuis la chambre 21 vers la chambre 23.

Le circulateur de ventilation 63 se présente par exemple sous la forme d'un impulseur ou ventilateur, pour forcer la circulation des flux d'air F3 et F4 lorsque le module 2 est en configuration de ventilation. Avantageusement, ce circulateur 63 est prévu à l'ouverture de ventilation basse 72. En particulier, ce circulateur 63 est prévu dans la chambre 23 entre l'ouverture 72 et l'ouverture 14. On pourrait prévoir en outre ou alternativement un circulateur de ventilation à l'ouverture de ventilation haute 71, par exemple dans la chambre secondaire haute 22, pour forcer la circulation des flux F3 et F4 en configuration de ventilation. Pour résumer, en configuration de ventilation, le ou les circulateurs de ventilation 63 mettent en circulation le flux d'air F3 successivement, en premier lieu, via l'ouverture 11, depuis l'extérieur jusque dans la chambre 21, en second lieu au travers de l'ouverture de ventilation basse 72, de la chambre 21 à la chambre 23, et en troisième lieu au travers de l'ouverture secondaire basse 14, depuis la chambre 23 jusque dans l'armoire 1. En configuration de ventilation, le ou les circulateurs de ventilation 63 mettent en circulation le flux d'air F4 successivement, en premier lieu, via l'ouverture 15, depuis l'armoire 1 jusque dans la chambre 22, en second lieu au travers de l'ouverture de ventilation haute 71, de la chambre 22 à la chambre 24, ou de la chambre 22 directement à l'extérieur. Si la chambre 24 est prévue, en troisième lieu, le flux F4 traverse l'ouverture 13, depuis la chambre 24 jusqu'à l'extérieur.

Dans l'exemple illustré sur la figure 1, l'ouverture de ventilation basse 72 est une ouverture qui est ouverte par la mise en circulation du flux d'air F3, et qui se referme d'elle-même, en l'absence du flux d'air F3. Il n'est donc pas nécessaire de prévoir un actionneur pour faire basculer l'ouverture 72 entre les configurations ouverte et fermée, car on tire partie du flux d'air F3 mis en mouvement par le circulateur 63. Par exemple, l'ouverture 72 est pourvue d'un clapet d'obturation de l'ouverture 72, ainsi que d'un organe de rappel du clapet vers une position de fermeture où le clapet obture l'ouverture 72. Le circulateur 63 est configuré pour entraîner le flux d'air F3 avec suffisamment de force pour que le flux F3 maintienne le clapet ouvert à l'encontre de l'organe de rappel.

On prévoit avantageusement des dispositions similaires pour l'ouverture 71, qui est alors ouverte sous l'action du flux F4, lorsque ce flux F4 est établi, et se refermer automatiquement, sans actionneur, en l'absence du flux F4. Pour cela, on prévoit avantageusement qu'un circulateur de ventilation est disposé à l'ouverture 71.

Plus généralement, on prévoit qu'au moins l'une des deux ouvertures de ventilation 71 et 72 s'ouvre par l'action du flux F3 ou F4 qui la traverse et se referme d'elle-même, par exemple sous l'action d'un organe de rappel tel qu'un ressort, en l'absence de ce flux F3 ou F4.

En variante, on prévoit qu'au moins l'une des ouvertures de ventilation 71 et 72 est pourvue d'un actionneur, par exemple un moteur électrique, qui met l'ouverture de ventilation concernée en position ouverte lorsque le module est en configuration de ventilation, et en position fermée lorsque le module est en configuration d'échange. Dans l'exemple de la figure 1, on prévoit que l'ouverture 72 est pourvue d'un tel actionneur, non représenté, qui actionne le clapet de l'ouverture 72 comme ceci.

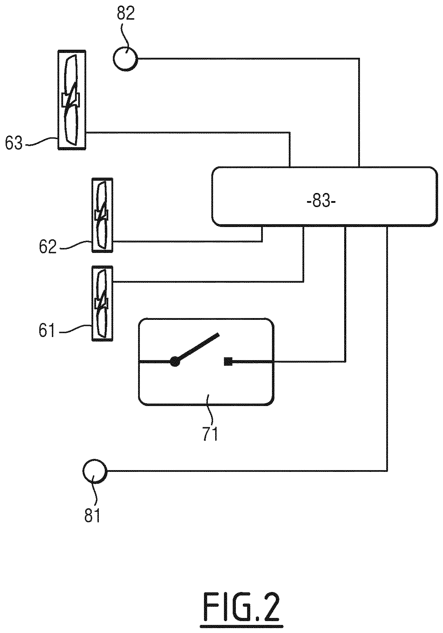

De préférence, le module 2 comprend un automate de commande 83, représenté fonctionnellement sur la figure 2, et des capteurs de température, parmi lesquels un capteur de température primaire 81 et un capteur de température secondaire 82, montrés sur les figures 1 et 2.

L'automate de commande 83 est préférentiellement un dispositif électronique, qui comprend par exemple une mémoire où est stocké un programme informatique et un processeur pour exécuter ce programme informatique, des circuits d'entrée reliant l'automate aux capteurs de température 81 et 82, et des circuits de commande reliant le processeur à différents organes du module 2, par exemple les circulateurs 61, 62 et 63, et à l'actionneur éventuel des ouvertures de ventilation 71 et 72. La figure 2 montre un exemple ou seule l'ouverture 71 comporte un actionneur, lequel est commandé par l'automate 83. Le processeur exécutant le programme, l'automate 83 commande, en fonction des informations de température fournie par les capteurs, les circulateurs 61, 62 et 63 et l'actionneur de l'ouverture de ventilation 71. L'automate 83 est configuré pour faire basculer le module 2 en configuration d'échange, en commandant l'activation des circulateurs 61 et 62 et l'arrêt du circulateur 63, tout en commandant la fermeture de l'ouverture 71. L'automate 83 est configuré pour faire basculer le module 2 en configuration de ventilation, en commandant l'arrêt des circulateurs 61 et 62 et l'activation du circulateur 63, tout en commandant l'ouverture de l'ouverture 71.

Par exemple, le capteur de température primaire 81 mesure la température T1. Dans le présent exemple, la température T1 est la température du flux d'air primaire F1 à l'ouverture primaire basse 11. Pour mesurer cette température T1, le capteur 81 est par exemple placé dans la chambre 21 à proximité de l'ouverture 11. Alternativement, le capteur 81 peut être placé sur la façade 6, à l'extérieur, de sorte que la température T1 mesurée est la température ambiante régnant à l'extérieur du module et de l'armoire électrique.

Le capteur de température secondaire 82 mesure la température T2 du flux d'air primaire F1 à l'ouverture primaire haute 12, en particulier au-dessus de l'échangeur 20. Pour mesurer cette température T2, le capteur 82 est par exemple placé dans la chambre 21 à proximité de l'ouverture 12.

L'écart entre les températures T1 et T2 témoigne de l'efficacité thermique de l'échangeur 20, et du module 2 en général. Lorsque l'échangeur 20 est encrassé ou défectueux, la différence entre les températures T2 et T1 réduit. Dès lors, par exemple, lorsque le module 2 est en configuration d'échange et que la différence entre les températures T2 et T1 est en deçà d'une valeur prédéterminée, l'automate 83 est préférentiellement configuré pour faire basculer le module 2 en configuration de ventilation, afin de garantir le bon refroidissement de l'armoire 1 même si l'échangeur 20 n'est plus efficace. Cette situation correspond à un mode dégradé de fonctionnement du module 2. Dès lors, on prévoit avantageusement que le module 2 comprend une alarme, incluant par exemple un avertisseur sonore audible par un utilisateur depuis l'extérieur du module 2 et de l'armoire 1, ou un avertisseur lumineux visible par un utilisateur depuis l'extérieur du module 2 et de l'armoire 1, l'alarme étant activée automatiquement par l'automate 83 pour prévenir que le module 2 a été basculé en configuration de ventilation et qu'une opération de maintenance doit être effectuée sur l'échangeur 20.

Toute caractéristique décrite ci-dessus pour l'un des modes de réalisation et variante susmentionnés peut être appliquée dans les autres modes de réalisation et variantes décrits ci-dessus.

## Revendications

1. Module de refroidissement (2), configuré pour être rapporté contre une façade extérieure (3) d'une armoire électrique (1) pour refroidir l'armoire électrique (1), le module de refroidissement (2) comprenant :
• un échangeur thermique (20) air-air ;
• une chambre primaire (21), délimitée par l'échangeur thermique (20) et comprenant une ouverture primaire haute (12) et une ouverture primaire basse (11), pour mettre en communication la chambre primaire (21) avec l'extérieur ;
• des chambres secondaires (22, 23), configurées pour être interposées entre la chambre primaire (21) et l'armoire électrique (1) lorsque le module de refroidissement (2) est rapporté contre l'armoire électrique (1), et comprenant :
◆une chambre secondaire haute (22), comprenant une ouverture secondaire haute (15), pour mettre en communication la chambre secondaire haute (22) avec l'armoire électrique (1) ;et
◆une chambre secondaire basse (23), comprenant une ouverture secondaire basse (14), pour mettre en communication la chambre secondaire basse (23) avec l'armoire électrique (1), la chambre secondaire haute (22) communiquant avec la chambre secondaire basse (23) par l'intermédiaire de l'échangeur thermique (20) ; et
• des circulateurs d'air (61, 62), qui, dans une configuration d'échange du module de refroidissement (2), mettent en circulation :
◆un flux d'air primaire (F1), successivement :
◊ via l'ouverture primaire basse (11), depuis l'extérieur jusque dans la chambre primaire (21) ;
◊ au travers de l'échangeur thermique (20) ;
◊ via l'ouverture primaire haute (12), depuis la chambre primaire (21) jusqu'à l'extérieur, via l'ouverture primaire haute (12) ; et
◆un flux d'air secondaire (F2), successivement :
◊ via l'ouverture secondaire haute (15), depuis l'armoire électrique (1) jusque dans la chambre secondaire haute (22) ;
◊ au travers de l'échangeur thermique (20) ;
◊ via l'ouverture secondaire basse (14), depuis la chambre secondaire basse (23) jusqu'à l'armoire électrique (1) ; où:
• le module de refroidissement (2) comprend une ouverture de ventilation haute (71), pour mettre en communication la chambre secondaire haute (22) avec l'extérieur, et une ouverture de ventilation basse (72), pour mettre en communication le chambre secondaire basse (23) avec la chambre primaire (21) ; et
• le module de refroidissement (2) est configuré pour être basculé entre la configuration d'échange, dans laquelle l'ouverture de ventilation haute (71) et l'ouverture de ventilation basse (72) sont fermées, et une configuration de ventilation, dans laquelle l'ouverture de ventilation haute (71) et l'ouverture de ventilation basse (72) sont ouvertes et dans laquelle les circulateurs d'air (63) mettent en circulation :
◆un flux d'air neuf (F3), depuis l'extérieur jusque dans l'armoire électrique (1), successivement au travers de l'ouverture primaire basse (11), de l'ouverture de ventilation basse (72) et de l'ouverture secondaire basse (14) ;
◆un flux d'air extrait (F4), depuis l'armoire électrique (1) jusqu'à l'extérieur, successivement au travers de l'ouverture secondaire haute (15) et de l'ouverture de ventilation haute (71).

2. Module de refroidissement (2) selon la revendication 1, dans lequel le module de refroidissement (2) comprend :
• une façade primaire (6), qui délimite la chambre primaire (21), qui porte l'ouverture primaire haute (12) et l'ouverture primaire basse (11) ; et
• une façade secondaire (7), qui délimite la chambre secondaire haute (22) et la chambre secondaire basse (23), qui porte l'ouverture secondaire basse (14) et l'ouverture secondaire haute (15), qui est opposée et parallèle à la façade primaire (6), et qui est configurée pour être rapportée contre l'armoire électrique (1) lorsque le module de refroidissement (2) est rapporté contre l'armoire électrique (1).

3. Module de refroidissement (2) selon la revendication 2, dans lequel le module de refroidissement (2) comprend :
• une ouverture d'extraction (13), ménagée au travers de la façade primaire (6) ; et
• une chambre d'extraction (24), agencée au-dessus de la chambre primaire (21) et mettant en communication l'ouverture de ventilation haute (71) avec l'ouverture d'extraction (13), de sorte que, en configuration de ventilation, le flux d'air extrait (F4) est mis en circulation par les circulateurs d'air (63) vers l'extérieur successivement au travers de la chambre d'extraction (24) et de l'ouverture d'extraction (13), après que le flux d'air extrait (F4) ait traversé l'ouverture de ventilation haute (71).

4. Module de refroidissement (2) selon l'une quelconque des revendications précédentes, dans lequel les circulateurs d'air (61, 62, 63) comprennent :
• un circulateur primaire (61), qui est disposé à une ouverture d'entrée primaire (32) de l'échangeur thermique (20), et qui, en configuration d'échange, force la circulation du flux d'air primaire (F1), l'ouverture d'entrée primaire (32) débouchant dans la chambre primaire (21) ;
• un circulateur secondaire (62), qui est disposé à une ouverture d'entrée secondaire (42) de l'échangeur thermique (20), et qui, en configuration d'échange, force la circulation du flux d'air secondaire (F2), l'ouverture d'entrée secondaire (42) débouchant dans la chambre secondaire haute (22) ; et
• un circulateur de ventilation (63), qui est disposé à l'ouverture de ventilation basse (72) ou à l'ouverture de ventilation haute (73) et qui, en configuration de ventilation, force la circulation du flux d'air neuf (F3) et du flux d'air extrait (F4).

5. Module de refroidissement (2) selon l'une quelconque des revendications précédentes, dans lequel au moins une ouverture, parmi l'ouverture de ventilation basse (72) et l'ouverture de ventilation haute (71), est configurée pour :
• être ouverte par l'action respectivement du flux d'air neuf (F3) et du flux d'air extrait (F4) ; et
• se refermer en l'absence du flux d'air neuf (F3) et du flux d'air extrait (F4).

6. Module de refroidissement (2) selon l'une quelconque des revendications précédentes, dans lequel :
• le module de refroidissement (2) comprend une cloison intermédiaire (16), qui sépare la chambre primaire (21) vis-à-vis des chambres secondaires (22, 23), les chambres secondaires (22, 23) communiquant avec l'échangeur thermique (20) par l'intermédiaire de la cloison intermédiaire (16) ; et
• l'échangeur thermique (20) comprend un assemblage modulaire de plusieurs batteries d'échange thermique (51), l'assemblage modulaire étant monté sur la cloison intermédiaire (16), de façon que chaque batterie d'échange thermique (51) soit accessible pour leur démontage depuis la chambre primaire (21), le nombre de batteries d'échange thermique (51) montées sur la cloison intermédiaire déterminant la puissance spécifique de l'échangeur thermique (20).

7. Module de refroidissement (2) selon la revendication 6, dans lequel les batteries d'échange thermique (51) sont agencées en colonne de sorte à être successivement traversées par le flux d'air secondaire (F2), de la batterie d'échange thermique (51) la plus haute jusqu'à la batterie d'échange thermique (51) la plus basse.

8. Module de refroidissement (2) selon l'une quelconque des revendications 6 ou 7, dans lequel la cloison intermédiaire (16) comprend des emplacements (52), chaque batterie d'échange thermique (51) de l'assemblage modulaire pouvant être montée à l'un des emplacements (52), chaque emplacement (52) comprenant une ouverture intermédiaire (44) respective, débouchant sur la chambre secondaire basse (23), l'ouverture intermédiaire (44) de chaque emplacement (52) sur lequel une batterie d'échange thermique (51) est montée étant recouverte par ladite batterie d'échange thermique (51), pour qu'une partie du flux d'air secondaire (F2) ayant traversé cette batterie d'échange thermique (51) soit évacuée dans la chambre secondaire basse (23) par l'intermédiaire de cette ouverture intermédiaire (44).

9. Module de refroidissement (2) selon l'une quelconque des revendications précédentes, dans lequel le module de refroidissement (2) comprend en outre un automate de commande (83) et des capteurs de température (81, 82), qui, en configuration d'échange, mesurent des températures (T1, T2) du flux d'air primaire (F1) et/ou du flux d'air secondaire (F2), l'automate de commande (83) faisant automatiquement basculer le module de refroidissement (2) de la configuration d'échange à la configuration de ventilation sur la base des températures (T1, T2) mesurées par les capteurs de température (81, 82).

10. Installation comprenant :
• le module de refroidissement (2) selon l'une quelconque des revendications précédentes ; et
• l'armoire électrique (1) présentant la façade extérieure (3) contre laquelle le module de refroidissement (2) est rapporté, de sorte que :
◆les chambres secondaires sont interposées entre l'armoire électrique (1) et la chambre primaire (21) ; et
◆l'ouverture secondaire haute (15) et l'ouverture secondaire basse (14) débouchent à l'intérieur de l'armoire électrique (1).

## Patentansprüche

1. Kühlmodul (2), das dazu ausgelegt ist, an einer Außenfassade (3) eines Schaltschranks (1) angebracht zu sein, um den Schaltschrank (1) zu kühlen, wobei das Kühlmodul (2) umfasst:
• einen Luft-Luft-Wärmetauscher (20);
• eine primäre Kammer (21), die von dem Wärmetauscher (20) begrenzt ist und eine obere primäre Öffnung (12) und eine untere primäre Öffnung (11) umfasst, um die primäre Kammer (21) mit außen in Kommunikation zu versetzen;
• sekundäre Kammern (22, 23), die dazu ausgelegt sind, zwischen der primären Kammer (21) und dem Schaltschrank (1) zwischengestellt zu sein, wenn das Kühlmodul (2) am Schaltschrank (1) angebracht ist, und umfassend:
◆ eine obere sekundäre Kammer (22), die eine obere sekundäre Öffnung (15) umfasst, um die obere sekundäre Kammer (22) mit dem Schaltschrank (1) in Kommunikation zu versetzen; und
◆ eine untere sekundäre Kammer (23), die eine untere sekundäre Öffnung (14) umfasst, um die untere sekundäre Kammer (23) mit dem Schaltschrank (1) in Kommunikation zu versetzen, wobei die obere sekundäre Kammer (22) mit der unteren sekundären Kammer (23) über den Wärmetauscher (20) kommuniziert; und
• Luftgebläse (61, 62), die in einer Austauschkonfiguration des Kühlmoduls (2) in Zirkulation versetzen:
◆ einen Primärluftstrom (F1), nacheinander:
◊ über die untere primäre Öffnung (11) von außen bis in die primäre Kammer (21);
◊ durch den Wärmetauscher (20);
◊ über die obere primäre Öffnung (12) von der primären Kammer (21) bis nach außen über die obere primäre Öffnung (12); und
◆ einen Sekundärluftstrom (F2), nacheinander:
◊ über die obere sekundäre Öffnung (15) vom Schaltschrank (1) bis in die obere sekundäre Kammer (22);
◊ durch den Wärmetauscher (20);
◊ über die untere sekundäre Öffnung (14) von der unteren sekundären Kammer (23) bis zum Schaltschrank (1);
wobei:
• das Kühlmodul (2) eine obere Lüftungsöffnung (71) umfasst, um die obere sekundäre Kammer (22) mit außen in Kommunikation zu versetzen, und eine untere Lüftungsöffnung (72), um die untere sekundäre Kammer (23) mit der primären Kammer (21) in Kommunikation zu versetzen; und
• das Kühlmodul (2) dazu ausgelegt ist, zwischen der Austauschkonfiguration, in der die obere Lüftungsöffnung (71) und die untere Lüftungsöffnung (72) geschlossen sind, und einer Lüftungskonfiguration, in der die obere Lüftungsöffnung (71) und die untere Lüftungsöffnung (72) geöffnet sind, umgeschaltet zu werden, und in der die Luftgebläse (63) in Zirkulation versetzen:
◆ einen Frischluftstrom (F3) von außen bis in den Schaltschrank (1) nacheinander durch die untere primäre Öffnung (11), die untere Lüftungsöffnung (72) und die untere sekundäre Öffnung (14);
◆ einen Abluftstrom (F4) vom Schaltschrank (1) nach außen nacheinander durch die obere sekundäre Öffnung (15) und die obere Lüftungsöffnung (71).

2. Kühlmodul (2) nach Anspruch 1, wobei das Kühlmodul (2) umfasst:
• eine primäre Fassade (6), die die primäre Kammer (21) begrenzt, die die obere primäre Öffnung (12) und die untere primäre Öffnung (11) trägt; und
• eine sekundäre Fassade (7), die die obere sekundäre Kammer (22) und die untere sekundäre Kammer (23) begrenzt, die die untere sekundäre Öffnung (14) und die obere sekundäre Öffnung (15) trägt, die der primären Fassade (6) gegenüberliegt und parallel zu ihr ist, und die dazu ausgelegt ist, am Schaltschrank (1) angebracht zu sein, wenn das Kühlmodul (2) am Schaltschrank (1) angebracht ist.

3. Kühlmodul (2) nach Anspruch 2, wobei das Kühlmodul (2) umfasst:
• eine Abluftöffnung (13), die durch die primäre Fassade (6) eingerichtet ist; und
• eine Abluftkammer (24), die oberhalb der primären Kammer (21) eingerichtet ist und die obere Lüftungsöffnung (71) mit der Abluftöffnung (13) in Kommunikation versetzt, so dass in Lüftungskonfiguration der Abluftstrom (F4) von den Luftgebläsen (63) nach außen nacheinander durch die Abluftkammer (24) und die Abluftöffnung (13) in Zirkulation versetzt wird, nachdem der Abluftstrom (F4) die obere Lüftungsöffnung (71) durchquert hat.

4. Kühlmodul (2) nach einem der vorangehenden Ansprüche, wobei die Luftgebläse (61, 62, 63) umfassen:
• ein primäres Gebläse (61), das an einer primären Einlassöffnung (32) des Wärmetauschers (20) angeordnet ist und das in Austauschkonfiguration die Zirkulation des Primärluftstroms (F1) erzwingt, wobei die primäre Einlassöffnung (32) in die primäre Kammer (21) ausmündet;
• ein sekundäres Gebläse (62), das an einer sekundären Einlassöffnung (42) des Wärmetauschers (20) angeordnet ist und das in Austauschkonfiguration die Zirkulation des Sekundärluftstroms (F2) erzwingt, wobei die sekundäre Einlassöffnung (42) in die obere sekundäre Kammer (22) ausmündet; und
• ein Lüftungsgebläse (63), das an der unteren Lüftungsöffnung (72) oder an der oberen Lüftungsöffnung (73) angeordnet ist und das in Lüftungskonfiguration die Zirkulation des Frischluftstroms (F3) und des Abluftstroms (F4) erzwingt.

5. Kühlmodul (2) nach einem der vorangehenden Ansprüche, wobei mindestens eine Öffnung von der unteren Lüftungsöffnung (72) und der oberen Lüftungsöffnung (71) dazu ausgelegt ist:
• durch die Wirkung jeweils des Frischluftstroms (F3) und des Abluftstroms (F4) geöffnet zu sein; und
• sich bei Abwesenheit des Frischluftstroms (F3) und des Abluftstroms (F4) zu schließen.

6. Kühlmodul (2) nach einem der vorangehenden Ansprüche, wobei:
• das Kühlmodul (2) eine Zwischenwand (16) umfasst, die die primäre Kammer (21) gegenüber den sekundären Kammern (22, 23) trennt, wobei die sekundären Kammern (22, 23) mit dem Wärmetauscher (20) über die Zwischenwand (16) kommunizieren; und
• der Wärmetauscher (20) eine modulare Montage aus mehreren Wärmetauschbatterien (51) umfasst, wobei die modulare Montage auf der Zwischenwand (16) derart angebracht ist, dass jede Wärmetauschbatterie (51) für ihre Demontage von der primären Kammer (21) aus erreichbar ist, wobei die Anzahl der auf der Zwischenwand angebrachten Wärmetauschbatterien (51) die spezifische Leistung des Wärmetauschers (20) bestimmt.

7. Kühlmodul (2) nach Anspruch 6, wobei die Wärmetauschbatterien (51) säulenförmig eingerichtet sind, so dass sie nacheinander vom Sekundärluftstrom (F2) von der obersten Wärmetauschbatterie (51) bis zur untersten Wärmetauschbatterie (51) durchquert werden.

8. Kühlmodul (2) nach einem der Ansprüche 6 oder 7, wobei die Zwischenwand (16) Stellen (52) umfasst, wobei jede Wärmetauschbatterie (51) der modularen Montage an einer der Stellen (52) anbringbar ist, wobei jede Stelle (52) eine jeweilige Zwischenöffnung (44) umfasst, die auf der unteren sekundären Kammer (23) ausmündet, wobei die Zwischenöffnung (44) jeder Stelle (52), auf der eine Wärmetauschbatterie (51) angebracht ist, von der Wärmetauschbatterie (51) bedeckt ist, damit ein Teil des Sekundärluftstroms (F2), der diese Wärmetauschbatterie (51) durchquert hat, in die untere sekundäre Kammer (23) über diese Zwischenöffnung (44) abgeleitet wird.

9. Kühlmodul (2) nach einem der vorangehenden Ansprüche, wobei das Kühlmodul (2) ferner eine Steuerautomatik (83) und Temperatursensoren (81, 82) umfasst, die in Austauschkonfiguration Temperaturen (T1, T2) des Primärluftstroms (F1) und/oder des Sekundärluftstroms (F2) messen, wobei die Steuerautomatik (83) bewirkt, dass das Kühlmodul (2) auf der Basis der von den Temperatursensoren (81, 82) gemessenen Temperaturen (T1, T2) automatisch aus der Austauschkonfiguration in die Lüftungskonfiguration verlagert wird.

10. Anlage, umfassend:
• das Kühlmodul (2) nach einem der vorangehenden Ansprüche; und
• den Schaltschrank (1), der die Außenfassade (3) aufweist, an der das Kühlmodul (2) angebracht ist, so dass:
◆ die sekundären Kammern zwischen dem Schaltschrank (1) und der primären Kammer (21) angeordnet sind; und
◆ die obere sekundäre Öffnung (15) und die untere sekundäre Öffnung (14) in das Innere des Schaltschranks (1) ausmünden.

## Claims

1. A cooling module (2), configured to be attached against an outer façade (3) of an electrical cabinet (1) to cool the electrical cabinet (1), the cooling module (2) comprising:
• an air-to-air heat exchanger (20);
• a primary chamber (21), delimited by the heat exchanger (20) and comprising an upper primary opening (12) and a lower primary opening (11), to place the primary chamber (21) in communication with the outside;
• secondary chambers (22, 23), configured to be interposed between the primary chamber (21) and the electrical cabinet (1) when the cooling module (2) is attached against the electrical cabinet (1), and comprising:
▪ an upper secondary chamber (22), comprising an upper secondary opening (15), to place the upper secondary chamber (22) in communication with the electrical cabinet (1); and
▪ a lower secondary chamber (23), comprising a lower secondary opening (14), to place the lower secondary chamber (23) in communication with the electrical cabinet (1), the upper secondary chamber (22) communicating with the lower secondary chamber (23) by means of the heat exchanger (20); and
• air circulators (61, 62), which, in an exchange configuration of the cooling module (2), circulate:
▪ a primary air flow (F1), successively:
∘ via the lower primary opening (11), from the outside into the primary chamber (21);
∘ through the heat exchanger (20);
∘ via the upper primary opening (12), from the primary chamber (21) to the outside, via the upper primary opening (12); and
▪ a secondary air flow (F2), successively:
∘ via the upper secondary opening (15), from the electrical cabinet (1) into the upper secondary chamber (22);
∘ through the heat exchanger (20);
∘ via the lower secondary opening (14), from the lower secondary chamber (23) to the electrical cabinet (1);
where:
• the cooling module (2) comprises an upper ventilation opening (71), to place the upper secondary chamber (22) in communication with the outside, and a lower ventilation opening (72), to place the lower secondary chamber (23) in communication with the primary chamber (21); and
• the cooling module (2) is configured to be switched between the exchange configuration, in which the upper ventilation opening (71) and the lower ventilation opening (72) are closed, and a ventilation configuration, in which the upper ventilation opening (71) and the lower ventilation opening (72) are open and in which the air circulators (63) circulate:
▪ a new air flow (F3), from the outside into the electrical cabinet (1), successively through the lower primary opening (11), the lower ventilation opening (72) and the lower secondary opening (14);
▪ an extracted airflow (F4), from the electrical cabinet (1) to the outside, successively through the upper secondary opening (15) and the upper ventilation opening (71).

2. The cooling module (2) according to claim 1, wherein the cooling module (2) comprises:
• a primary façade (6), which delimits the primary chamber (21), which bears the upper primary opening (12) and the lower primary opening (11); and
• a secondary façade (7), which delimits the upper secondary chamber (22) and the lower secondary chamber (23), which bears the lower secondary opening (14) and the upper secondary opening (15), which is opposite and parallel to the primary façade (6), and which is configured to be attached against the electrical cabinet (1) when the cooling module (2) is attached against the electrical cabinet (1).

3. The cooling module (2) according to claim 2, wherein the cooling module (2) comprises:
• an extraction opening (13), arranged through the primary façade (6); and
• an extraction chamber (24), arranged above the primary chamber (21) and placing the upper ventilation opening (71) in communication with the extraction opening (13), such that, in the ventilation configuration, the extracted airflow (F4) is circulated by the air circulators (63) toward the outside successively through the extraction chamber (24) and the extraction opening (13), after the extracted airflow (F4) has passed through the upper ventilation opening (71).

4. The cooling module (2) according to any one of the preceding claims, wherein the air circulators (61, 62, 63) comprise:
• a primary circulator (61), which is arranged at a primary inlet opening (32) of the heat exchanger (20), and which, in the exchange configuration, forces the circulation of the primary airflow (F1), the primary inlet opening (32) opening into the primary chamber (21);
• a secondary circulator (62), which is arranged at a secondary inlet opening (42) of the heat exchanger (20), and which, in the exchange configuration, forces the circulation of the secondary airflow (F2), the secondary inlet opening (42) opening into the upper secondary chamber (22); and
• a ventilation circulator (63), which is arranged at the lower ventilation opening (72) or at the upper ventilation opening (73) and which, in the ventilation configuration, forces the circulation of the new airflow (F3) and the extracted airflow (F4).

5. The cooling module (2) according to any one of the preceding claims, wherein at least one opening, among the lower ventilation opening (72) and the upper ventilation opening (71), is configured to:
• be opened by the action of the new airflow (F3) and the extracted airflow (F4), respectively; and
• close in the absence of the new airflow (F3) and the extracted airflow (F4).

6. The cooling module (2) according to any one of the preceding claims, wherein:
• the cooling module (2) comprises an intermediate partition (16), which separates the primary chamber (21) with respect to the secondary chambers (22, 23), the secondary chambers (22, 23) communicating with the heat exchanger (20) by means of the intermediate partition (16); and
• the heat exchanger (20) comprises a modular assembly of several heat exchange batteries (51), the modular assembly being mounted on the intermediate partition (16), such that each heat exchange battery (51) is accessible for disassembly thereof from the primary chamber (21), the number of heat exchange batteries (51) mounted on the intermediate partition determining the specific power of the heat exchanger (20).

7. The cooling module (2) according to claim 6, wherein the heat exchange batteries (51) are arranged in a column so as to be successively passed through by the secondary airflow (F2), from the highest heat exchange battery (51) to the lowest heat exchange battery (51).

8. The cooling module (2) according to any one of claims 6 or 7, wherein the immediate partition (16) comprises locations (52), each heat exchange battery (51) of the modular assembly being able to be mounted in one of the locations (52), each location (52) comprising a respective intermediate opening (44), opening onto the lower secondary chamber (23), the intermediate opening (44) of each location (52) on which a heat exchange battery (51) is mounted being covered by said heat exchange battery (51), in order for part of the secondary airflow (F2) having passed through this heat exchange battery (51) to be discharged into the lower secondary chamber (23) by means of this intermediate opening (44).

9. The cooling module (2) according to any one of the preceding claims, wherein the cooling module (2) further comprises a control automaton (83) and temperature sensors (81, 82), which, in the exchange configuration, measure temperatures (T1, T2) of the primary airflow (F1) and/or of the secondary airflow (F2), the control automaton (83) automatically switching the cooling module (2) from the exchange configuration to the ventilation configuration based on the temperatures (T1, T2) measured by the temperature sensors (81, 82).

10. An installation comprising:
• the cooling module (2) according to any one of the preceding claims; and
• the electrical cabinet (1) having the outer façade (3) against which the cooling module (2) is attached, such that:
▪ the secondary chambers are interposed between the electrical cabinet (1) and the primary chamber (21); and
▪ the upper secondary opening (15) and the lower secondary opening (14) open inside the electrical cabinet (1).
